(19) Europäisches Patentamt / European Patent Office / Office européen des brevets

(11) **EP 2 562 821 A1**

(12) **EUROPEAN PATENT APPLICATION**
published in accordance with Art. 153(4) EPC

(43) Date of publication:
**27.02.2013 Bulletin 2013/09**

(51) Int Cl.:
**H01L 31/042** (2006.01)   **C08F 210/00** (2006.01)
**C08F 232/00** (2006.01)   **H01L 33/56** (2010.01)

(21) Application number: **11771924.5**

(22) Date of filing: **13.04.2011**

(86) International application number:
**PCT/JP2011/059217**

(87) International publication number:
**WO 2011/132589 (27.10.2011 Gazette 2011/43)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **07.10.2010 JP 2010227867**
**22.04.2010 JP 2010099053**

(71) Applicant: **Daicel Corporation**
**Osaka-shi, Osaka 530-0001 (JP)**

(72) Inventors:
• **TAKARAGI Akira**
 **Himeji-shi**
 **Hyogo 671-1283 (JP)**
• **IWAHAMA Takahiro**
 **Himeji-shi**
 **Hyogo 671-1283 (JP)**
• **TEI Takahiro**
 **Himeji-shi**
 **Hyogo 671-1283 (JP)**
• **TOMOYOSE Ryuta**
 **Himeji-shi**
 **Hyogo 671-1283 (JP)**

(74) Representative: **Grünecker, Kinkeldey,**
**Stockmair & Schwanhäusser**
**Leopoldstrasse 4**
**80802 München (DE)**

(54) **OPTICAL SEMICONDUCTOR PROTECTIVE MATERIAL, PRECURSOR FOR SAME, AND METHOD FOR MANUFACTURING OPTICAL SEMICONDUCTOR PROTECTIVE MATERIAL**

(57)    A photosemiconductor protective material comprising a chain olefin-cyclic olefin copolymer elastomer composed of a chain olefin and a cyclic alevin as polymerizable components is prepared. The elastomer may comprise an $\alpha$-chain $C_{2-4}$ olefin and a polycyclic olefin as polymerizable components, and the molar ratio of the $\alpha$-chain $C_{2-4}$ olefin relative to the polycyclic olefin may be 80/20 to 99/1 in a ratio of the $\alpha$-chain $C_{2-4}$ olefin/the polycyclic olefin. The photosemiconductor protective material may further contain an organic silicon compound having a hydrolytically condensable group. The organic silicon compound may be a silane coupling agent having a (meth) acryloyl group. A photosemiconductor protective material 1 as the protective maternal is suitable as a solar cell encapsulant or filler 3 for encapsulating a solar cell 4. The photosemiconductor protective material has a high transparency and a high weather resistance and a proper elasticity and effectively protests a photosemiconductor.

Fig. 1

EP 2 562 821 A1

## Description

TECHNICAL FIELD

The present invention relates to a projective material (or encapsulant) for a photosemiconductor used for a solar cell device, a light emitting diode (LED), an inorganic or organic EL device, and other devices, a precursor thereof, and a process for producing a photosemiconductor protective material.

BACKGROUND ART

Photosemiconductors are used for various applications, for example, a solar cell for converting light energy into electrical energy and a light emitting device (e.g., an LED and an inorganic or organic EL). It is necessary to protect these photosemiconductors against an external impact or abrasion while maintaining the transparency, and against corrosion by avoiding moisture or water depending on the applications.

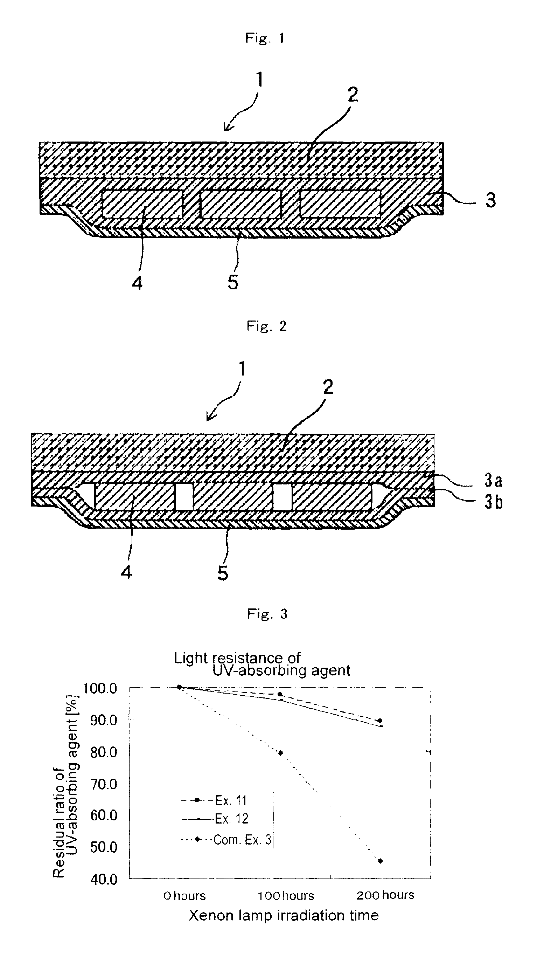

To take a solar cell device as an example, as shown in Fig. 1, a solar cell device (module) 1 comprises a front glass 2, an encapsulant 3, a back sheet 5, and a solar cell 4 encapsulated in the encapsulant 3 between the front glass 2 and the back sheet 5, the solar cell 4 being tightly fixed between the front glass 2 and the back sheet 5 with the encapsulant (or filler) 3 composed of an adhesive polymer. The solar cell device 1 is, as shown in Fig. 2, obtainable by stacking, in sequence, a front glass 2, an encapsulant sheet (or encapsulant precursor) 3a, a solar cell 2, a encapsulant sheet 3b, and a back sheet 5 and then subjecting the resulting stack of layers to heat lamination. Specifically, by the heat lamination, the encapsulant sheet 3a on the side of the front glass and the encapsulant sheet 3b on the side of the back sheet are melted to flow in a gap between the solar cells 4 and are united to form an encapsulant 3. The encapsulant (or encapsulant sheet) needs adhesion to the front glass, the solar cell and the back sheet, transparency for light penetration, elasticity or suffering property for protecting a solar cell or a wire (not shown), weather resistance (heat resistance and light resistance) for maintaining the transparency or the elasticity, dampproofing property (gas barrier property) for avoiding moisture, and other properties. Moreover, in manufacturing a solar cell device (module), it is necessary to easily thermocompressing whole stacked members for lamination treatment.

As the solar cell encapsulant, a sheet composed of an ethylene-vinyl acetate copolymer is widely used. This sheet, however, has an insufficient dampproofing property, adhesion, or weather resistance. For example, due to an acetyl group existing in the copolymer, a free acid is produced by pyrolysis in lamination treatment or by prolonged use, resulting in easy corrosion or foaming in the cell. In particular, since the solar cell encapsulant is exposed to sunlight, wind and rain in the open air for a long period of time to use, the encapsulant needs a high weather resistance. This encapsulant, however, has an insufficient weather resistance, particularly, an insufficient durability under sunlight exposure (light resistance). Moreover, the encapsulant is highly hydrophilic due to a polar group (such as an acetate group or hydroxyl group) present therein and has a disadvantage in the dampproofing property. Accordingly, the improvement of the solar cell encapsulant is made in order to possess these properties advantageously.

Japanese Patent Application Laid-Open Publication No. 2004-214641 (JP-2004-214641A, Patent Document 1) discloses a filler sheet for a solar cell module, and the sheet comprises a polymer composition comprising a copolymer of an $\alpha$-olefin and an ethylenic unsaturated silane compound or a modified product or condensation product of the copolymer, and at least one member selected from the group consisting of a light-resistant agent, an ultraviolet ray absorbing agent, and a heat stabilizer. According to this document, specifically, the solar cell module is produced by mixing a polyolefin (such as a polyethylene), a silane coupling agent (such as vinyltrimethoxysilane), and a free-radical generator to give a modified olefin film and then laminating the resulting film as an encapsulant and a solar cell by a vacuum laminator.

Unfortunately, since this encapsulant has a high elastic modulus in a temperature range from a room temperature to 100°C, it is difficult to absorb distortion caused by expansion or contraction following temperature changes in the field environment. Thus, the encapsulant protects the cell insufficiently. Further, the encapsulant has low adhesion and low transparency.

Japanese Patent Application Laid-Open Publication No. 8-306947 (JP-8-306947A, Patent Document 2) discloses a rear protective layer for a solar cell module, and the rear protective layer comprises a laminated product including a first film composed of a fluoropolymer or a poly(methyl methacrylate) and a second film composed of a noncrystalline cyclic olefin copolymer having a glass transition temperature of not lower than 80°C and being laminated on an internal surface of the first film.

The rear protective layer, however, comprises a hard polymer and has a low elasticity or a low adhesion, thus the rear protective layer is difficult to use as an encapsulant.

Meanwhile, Japanese Patent No. 3274702 (JP-3274702B, Patent Document 3) reports a multilayered material which comprises a layer containing a cyclic olefinic copolymer having a glass transition temperature of not higher than 30°C and a layer or formed product composed of at least one material selected from the group consisting of a synthetic polymer, a natural polymer, a metal, a metal oxide, and a mixture thereof. As the synthetic polymer, various thermoplastic polymers, thermoplastic elastomers, thermosetting polymers are described in this Document. In Examples of the patent document, a cyclic olefinic copolymer film having a degree of crystallinity of 1%, a glass transition temperature of 2°C or 3°C, and a melting point of 81°C or 73°C is heat-laminated to a LLDPE (a linear low-density polyethylene) sheet, a nylon 6 sheet, a polyimide sheet, or an aluminum plate.

Although this document describes that the multilayered material can be used in a variety of fields, such as a film, a sheet, a container, a packaging material, an automotive part, an electric or electronic part, a building material, and a civil engineering material, there is no description about a photosemiconductor projective material.

RELATED ART DOCUMENTS

PATENT DOCUMENTS

Patent Document 1: JP-2004-214641A (Claim 1, Examples)
Patent Document 2: JP-8-306947A (Claim 1)
Patent Document 3: JP-3274702B (Claims, Paragraphs [0019] and [0057], and Examples)

SUMMARY OF THE INVENTION

PROBLEMS TO BE SOLVED BY THE INVENTION

It is therefore an object of the present invention to provide a photosemiconductor protective material having a high transparency, a high weather resistance (heat resistance and light resistance) and a proper elasticity and being capable of effectively protecting a photosemiconductor, and a precursor thereof, as well as a process for producing the photosemiconductor protective Material.

Another object of the present invention is to provide a photosemiconductor protective material having a high adhesion, and a precursor thereof, as well as a process for producing the photosemiconductor protective material.

It is still another object of the present invention to provide a photosemiconductor protective material having an excellent gas barrier property (for example, a barrier property against water vapor), a precursor thereof, and a process for producing the photosemiconductor protective material.

It is a further object of the present invention to provide a photosemiconductor protective material which allows the decomposition of a stabilizer (such as an ultraviolet ray absorbing agent) to be inhibited even in a long-term use and has an excellent light resistance, and a precursor thereof, as well as a process for producing the photosemiconductor protective material.

An even further object of the present invention is to provide a photosemiconductor protective material having a high adhesion to an inorganic material (such as a glass substrate or a silicon cell) and being suitable for a solar cell encapsulant (or filler), and a precursor thereof, as well as a process for producing the photosemiconductor protective material.

MEANS TO SOLVE THE PROBLEMS

The inventors of the present invention made intensive studies to achieve the above objects and finally found that a chain olefin-cyclic olefin copolymer elastomer ensures a high transparency, a high weather resistance (heat resistance and light resistance), and a proper elasticity and effectively protects a photosemiconductor (or an optical semiconductor). The present invention was accomplished based on the above findings.

That is, the photosemiconductor protective material of the present invention is a protective material for protecting a photosemiconductor and comprises a chain olefin-cyclic olefin copolymer elastomer comprising a chain olefin and a cyclic olefin as polymerizable components. The chain olefin-cyclic olefin copolymer elastomer may comprise an $\alpha$-chain $C_{2-4}$olefin and a polycyclic olefin as polymerizable components. The molar ratio of the $\alpha$-chain $C_{2-4}$olefin relative to the polycyclic olefin may be about 80/20 to 99/1 in a ratio of the $\alpha$-chain $C_{2-4}$olefin/the polycyclic olefin. The chain olefin-cyclic olefin copolymer elastomer may have a degree of crystallinity of not higher than 20% and a glass transition temperature of not higher than 30°C. Moreover, the chain olefin-cyclic olefin copolymer elastomer may have a storage modulus $E'$ of about 50 to 200 MPa at 25°C. The photosemiconductor protective material of the present invention may further contain an organic silicon compound having a hydrolytically condensable group. The organic silicon compound may be at least one member selected from the group consisting of an alkyltri$C_{1-4}$alkoxysilane, a silane coupling agent having a vinyl group, and a silane coupling agent having a (meth) acryloyl group [in particular, a silane coupling agent having a (meth) acryloyl group]. The ratio of the organic silicon compound is about 0.01 to 20 parts by weight relative to 100 parts by weight of the chain olefin-cyclic olefin copolymer elastomer. The photosemiconductor protective material of the present invention may further contain a radical generator. The radical generator may have a one-hour half-life temperature higher than a melting point of the chain olefin-cyclic olefin copolymer elastomer. The ratio of the radical generator is about 0.01 to 5 parts by weight relative to 100 parts by weight of the chain olefin-cyclic olefin copolymer elastomer. The photosemiconductor protective material of the present invention may further contain a crosslinking agent. The crosslinking agent may have not less than 2 vinyl groups in a molecule thereof. The ratio of the crosslinking agent is about 0.01 to 5 parts by weight relative to 100 parts by weight of the chain olefin-cyclic olefin copolymer elastomer. The photosemiconductor protective material of the present invention may further contain an ultraviolet ray absorbing agent (or UV-absorbing agent). The photosemiconductor protective material containing the ultraviolet ray absorbing agent has an excellent light resistance and may have a residual ratio of the ultraviolet ray absorbing agent of not less than 80% after xenon lamp irradiation at an irradiance of 180 W/m$^2$ for 200 hours at a blackpanel temperature of $44 \pm 2°C$. The photosemiconductor protective material of the present invention may have a storage modulus E' of 50 to 200 MPa at 25°C. The photosemiconductor protective material may have a haze of not more than 20% in a method (0.5 mm thick) in accordance with JIS (Japanese Industrial Standards) K7105. The photosemiconductor protective material of the present invention is suitable for a solar cell encapsulant or filler.

The present invention also includes a precursor of a photosemiconductor protective material; the precursor is a melt-kneaded product of a polymer composition comprising: a chain olefin-cyclic olefin copolymer elastomer comprising a chain olefin and a cyclic olefin as polymerizable components, and at least one member selected from the group consisting of a silane coupling agent having a polymerizable group and a radical generator. The melting temperature of the polymer composition may be lower than a one-hour half-life temperature of the radical generator. The precursor may be in the form of a sheet.

The present invention also includes a process for producing a photosemiconductor projective material; the process comprises treating the precursor with heat or an actinicray. In this production process, the treatment with heat may be carried out at a temperature not lower than a one-hour half-life temperature of the radical generator.

Further, the present invention includes a solar cell module provided with the solar cell encapsulant or filler and provided with not back sheet.

The present invention also includes a method of using a protective material for protecting a photosemiconductor; the protective material comprises a chain olefin-cyclic olefin copolymer elastomer comprising a chain olefin and a cyclic olefin as polymerizable components. Further, the present invention includes a method of using the precursor as a photosemiconductor projective material.


AFFECTS OF THE INVENTION

According to the present invention, the photosemiconductor protective material containing a chain olefin-cyclic olefin copolymer elastomer has a high transparency, a high weather resistance (heat resistance and light resistance), and a proper elasticity; thus she material achieves effective protection of a photosemiconductor. Moreover, the projective material is suitable for a solar cell encapsulant (or filler) and the like due to a high adhesion thereof, for example, a high adhesion to an inorganic material (e.g., a glass substrate and a silicon cell). For example, a photosemiconductor and two sheets of the protective material of the present invention, one of the sheets residing on a light-receiving side of the semiconductor and the other residing on a back (rear) side thereof, can easily adhere together by lamination and be united; the sheet having an excellent optical property presides on the back side of the photosemiconductor, thus a transmitted light, which has not been used for a photosemiconductor, is reflected to be reusable. Moreover, since the decomposition of a stabilizer such as an ultraviolet ray absorbing agent (in particular, a benzophenone-based ultraviolet ray absorbing agent) can be inhibited even in a long-term use, the projective material has an excellent light resistance. Further, the projective material also has an excellent gas barrier property (for example, a barrier property against water vapor). In particular, since the photosemiconductor has an excellent dampproofing property in a back side thereof, a back sheet can be omitted from a solar cell device (module) provided with the photosemiconductor.


BRIEF DESCRIPTION OF DRAWINGS

[Fig. 1] Fig. 1 is a schematic view showing a laminated structure of a solar cell device.
[Fig. 2] Fig. 2 is a schematic view showing a laminated structure of a solar cell device before heat lamination.
[Fig. 3] Fig. 3 is a graph showing a light resistance of an ultraviolet ray absorbing agent in polymer sheets obtained in Examples 11 and 12 and comparative Example 3.

# EP 2 562 821 A1

DESCRIPTION OF EMBODIMENTS

[Chain olefin-cyclic olefin copolymer elastomer]

The photosemiconductor protective material of the present invention comprises a chain olefin-cyclic olefin copolymer elastomer comprising a chain olefin and a cyclic olefin as polymerizable components. The copolymer elastomer is free from a polar group and has excellent chemical stability, barrier property against water vapor, and optical property. Moreover, the copolymer elastomer has a proper elasticity (cushion property), which achieves both protection and adhesion properties. Further, since the copolymer elastomer has a main chain structure having a large number of tertiary carbon atoms, a hydrogen atom is easily extracted by radical; the copolymer elastomer has an excellent radical reactivity in the coexistence with a coupling agent having a radical-polymerizable group or a crosslinking agent.

The chain olefin may include, for example, a chain $C_{2-10}$ olefin such as ethylene, propylene, 1-butene, isobutene, 1-pentene, 3-methyl-1-pentene, 4-methyl-1-pentene, 1-hexene, or 1-octene. These chain olefins may be used alone or in combination. Among these chain olefins, an $\alpha$-chain $C_{2-8}$ olefin is preferred, and an $\alpha$-chain $C_{2-4}$ olefin (particularly, ethylene) is more preferred.

It is sufficient that the cyclic olefin is a polymerizable cyclic olefin having an ethylenic double bond in a ring thereof. The cyclic olefin may be a monocyclic olefin (e.g., a cyclic $C_{4-12}$ cycloolefin such as cyclobutene, cyclopentene, cycloheptene, or cyclooctene). The cyclic olefin is preferably a polycyclic olefin.

Representative examples of the polycyclic olefin may include norbornene, a norbornene having a substituent (2-norbornene), an oligomer or polymer of cyclopentadiene, and a polymer of cyclopentadiene having a substituent. As the substituent, there may be mentioned an alkyl group, an alkenyl group, an aryl group, hydroxyl group, an alkoxy group, a carboxyl group, an alkoxycarbonyl group, an acyl group, cyano group, an amide group, a halogen atom, and other groups or atoms.

Specifically, the polycyclic olefin may include, for example, 2-norbornene; a norbornene compound having an alkyl group, such as 5-methyl-2-norbornene, 5,5-dimethyl-2-norbornene, 5-ethyl-2-norbornene, or 5-butyl-2-norbornene; a norbornene compound having an alkenyl group, such as 5-ethylidene-2-norbornene; a norbornene compound having an alkoxycarbonyl group, such as 5-methoxycarbonyl-2-norbornene or 5-methyl-5-methoxycarbonyl-2-norbornene; a norbornene compound having cyano group, such as 5-cyano-2-norbornene; a norbornene compound having an aryl group, such as 5-phenyl-2-norbornene or 5-phenyl-5-methyl-2-norbornene; dicyclopentadiene; a derivative such as 2,3-dihydrodicyclopentadiene, methanooctahydrofluorene, dimethanooctahydronaphthalene, dimethanocyclopentadienonaphthalene, or methanooctahydrocyclopentadienonaphthalene; a derivative having a substituent, such as 6-ethyl-octahydronaphthalene; an adduct of cyclopentadiene and tetrahydroindene or the like, and a trimer or tetramer of cyclopentadiene.

These cyclic olefins may be used alone or in combination. Among these cyclic olefins, a polycyclic olefin such as a norbornene compound is preferred.

In the chain olefin-cyclic olefin copolymer, from the viewpoint of compatibility between transparency and softness (or flexibility), the ratio (molar ratio) of the chain olefin (particularly, an $\alpha$-chain $C_{2-4}$ olefin such as ethylene) relative to the cyclic olefin (particularly, a polycyclic olefin such as norbornene) is, for example, about 80/20 to 99/1 (e.g., about 82/18 to 97/3), preferably about 85/15 to 95/5 (e.g., about 87/13 to 94/6), and more preferably about 88/12 to 93/7 (particularly, about 89/11 to 92/8) in a ratio of the former/the latter.

Other copolymerizable monomers may include, for example, vinyl ester monomer (such as vinyl acetate or vinyl propionate); a diene monomer (such as butadiene or isoprene); and a (meth) acrylicmonomer [e.g., (meth) acrylic acid or a derivative whereof (such as (meth)acrylate)]. These other copolymerizable monomers may be used alone or in combination. The proportion of these other copolymerizable monomers is, for example, not more than 5% by mol and preferably not more than 1% by mol in the copolymer.

The chain olefin-cyclic olefin copolymer elastomer may be an elastomer obtainable by addition polymerization or may be a polymer obtainable by ring-opening polymerization (e.g., ring-opening metathesis polymerization). Moreover, the polymer elastomer obtainable by ring-opening metathesis polymerization may be a hydrogenated product. The chain olefin-cyclic olefin copolymer elastomer may be obtained by a conventional polymerization method, for example, a ring-opening metathesis polymerization using a metathesis polymerization catalyst, an addition polymerization using a Ziegler catalyst, and an addition polymerization using a metallocene catalyst (usually, a ring-opening metathesis polymerization using a metathesis polymerization catalyst).

The degree of crystallinity of the chain olefin-cyclic olefin copolymer elastomer can be selected from the range of about not higher than 20% and is, for example, about 0.1 to 20%, preferably about 1 to 18%, more preferably about 2 to 15% (particularly, about 3 to 10%). The degree of crystallinity can be measured by an X-ray diffractometer as described in after-mentioned Examples.

The glass transition temperature (Tg) of the chain olefin-cyclic olefin copolymer elastomer can be selected from the range of about not higher than 30°C and is, for example, about -25°C to 30°C, preferably about -20°C to 20°C, and more preferably about -15°C to 10°C (particularly, about -10°C to 5°C).

The melting point (Tm) of the chain olefin-cyclic olefin copolymer elastomer can be selected from the range of about not lower than 50°C and is, for example, about 50 to 200°C, preferably about 60 to 150°C, and more preferably about 70 to 120°C (particularly, about 75 to 100°C).

The glass transition temperature and the melting point can be controlled by adjusting the ratio of the monomer, the substituent of the monomer, the molecular weight of the polymer, and others. The glass transition temperature and the melting point can be measured by a differential scanning calorimeter as described in after-mentioned Examples.

The chain olefin-cyclic olefin copolymer elastomer has excellent elasticity and softness (or flexibility) and has a storage modulus E' of, for example, about 30 to 300 MPa, preferably about 50 to 200 MPa, and more preferably about 60 to 180 MPa (particularly, about 80 to 150 MPa) at 25°C. According to the present invention, since the copolymer elastomer has such a proper elasticity, for example, use of the copolymer elastomer as a solar cell encapsulant achieves the absorption of a residual stress in laminating of the copolymer elastomer in producing a power-generation device or the absorption of an external impact to a module. Further, the copolymer elastomer can relax (or ease) dimensional change caused by a mechanical stress or temperature and humidity changes in processing or using.

In a tensile test (a film having a thickness of 100 μm) in accordance with JIS K7127, the chain olefin-cyclic olefin copolymer elastomer may have a breaking elongation of about not less than 500%, for example, about 500 to 2500%, preferably about 600 to 2000%, and more preferably about 800 to 1800% (particularly, about 1000 to 1500%). Since the copolymer elastomer shows elastic deformation, it is preferable that the copolymer elastomer do not have a yield point in the tensile test.

The chain olefin-cyclic olefin copolymer elastomer has a number average molecular weight of, for example, about 15000 to 200000, preferably about 20000 to 100000, and more preferably about 30000 to 80000 (particularly, about 40000 to 70000).

The chain olefin-cyclic olefin copolymer elastomer also has an excellent transparency. In a method (0.5 mm thick) in accordance with JIS K7105, the copolymer elastomer has a total light transmittance of not less than 80%, preferably about 85 to 99%, and more preferably about 88 to 98% (particularly, about 90 to 95%) and a haze of not more than 30% (e.g., about 1 to 30%), preferably about 2 to 20% (e.g., about 3 to 15%), and more preferably about 5 to 12% (particularly, about 6 to 9%). The total light transmittance and the haze can be measured according to methods as described in after-mentioned Examples.

The chain olefin-cyclic olefin copolymer elastomer has a melt viscosity at 150°C of, for example, about $1 \times 10^3$ to $1 \times 10^5$ Pa, preferably about $5 \times 10^3$ to $5 \times 10^4$ Pa, and more preferably about $1 \times 10^4$ to $3 \times 10^4$ Pa. In the present invention, the copolymer elastomer having a low melting point shows a high melt-fluidity (or fusibility and fluidity) at a low temperature and has an excellent sheet-formability. Moreover, in the case of use for a solar cell encapsulant or the like, since the copolymer elastomer is easily subjected to lamination and has a high infiltration property (or permeability), a solar cell or a wire can be tightly encapsulated with the copolymer elastomer.

The chain olefin-cyclic olefin copolymer elastomer has an excellent gas barrier property (particularly, a barrier property against water vapor). The copolymer elastomer has a water-vapor permeability under an atmosphere at a temperature of 60°C and a humidity of 90%RH (per 100 μm thick) of, for example, not more than 100 g/m²·day (for example, about 0.1 to 100 g/m²·day), preferably not more than 80 g/m²·day (e.g., not more than 0.5 to 80 g/m²·day), more preferably not more than 60 g/m²·day (e.g., not more than 1 to 60 g/m²·day), and particularly not more than 50 g/m²·day (e.g., about 5 to 50 g/m²·day). According to the present invention, the copolymer elastomer has a barrier property against water vapor about not less than twice as high as an ethylene-vinyl acetate copolymer widely used as a solar cell encapsulant has.

[Organic silicon compound having hydrolytically condensable group]

The photosemiconductor protective material of the present invention may further contain an organic silicon compound having a hydrolytically condensable group in order to improve the adhesion (in particular, adhesion to an inorganic material such as a glass substrate or a silicon cell). According to the present invention, addition of the organic silicon compound to the protective material for a solar cell encapsulant achieves proper adhesion of a light-receiving glass or a solar cell of a module to the encapsulant to prevent the encapsulant from separating. Thus, the photosemiconductor protective material can maintain the airtightness and prevent the generation of an air bubble.

The organic silicon compound having a hydrolytically condensable group may include, for Example, a tetraC$_{1-4}$alkoxysilane such as tetramethoxysilane or tetraethoxysilane; a C$_{1-12}$alkyltriC$_{1-4}$alkoxysilane such as methyltrimethoxysilane, ethyltrimethoxysilane, (iso)propyltrimethoxysilane, butyltrimethoxysilane, hexyltrimethoxysilane, octyltriethoxysilane, or decyltrimethoxysilane; a diC$_{1-12}$alkydiC$_{1-4}$alkoxysilane such as dimethyldimethoxysilane, diisopropyldimethoxysilane, or diisobutyldimethoxysilane; and an arylC$_{1-4}$alkoxysilane such as phenyltrimethoxysilane or diphenyldimethoxysilane.

The organic silicon compound may be what is called a silane coupling agent. Examples of the silane coupling agent may include a silane coupling agent having an epoxy group [e.g., a $C_{1-4}$alkyltri$C_{1-4}$alkoxysilane having an alicyclic epoxy group, such as 3,4-epoxycyclohexylmethyltripropoxysilane, 2-(3,4-epoxycyclohexyl)ethyltrimethoxysilane, 3-(3,4-epoxycyclohexyl)propyltrimethoxysilane; a glycidyloxy$C_{1-4}$alkyltri$C_{1-4}$alkoxysilane such as glycidyloxymethyltrimethoxysilane, 2-glycidyloxyethyltrimethoxysilane, 3-glycidyloxypropyltrimethoxysilane, 3-glycidyloxypropyltributoxysilane; and 3-(2-glycidyloxyethoxy)propyltrimethoxysilane], a silane coupling agent having an amino group [e.g., an amino-$C_{2-4}$alkyl$C_{1-4}$alkoxysilane such as aminomethyltriethoxysilane, 2-aminoethyltrimethoxysilane, 1-aminoethyltrimethoxysilane, 3-aminopropyltrimethoxysilane, 3-aminopropyltriethoxysilane, or 3-aminopropylmethyldimethoxysilane; and an N-amino$C_{1-4}$alkylamino$C_{1-4}$alkyltri$C_{1-4}$alkoxysilane such as N-aminomethylaminomethyltrimethoxysilane, 3-(N-aminomethylamino)propyltrimethoxysilane, or 3-[N-(2-aminoethyl)amino]propyltrimethoxysilane], a silane coupling agent having an ethylenic unsaturated bond group [e.g., a silane coupling agent having a vinyl group (e.g., a vinyl- tri$C_{1-4}$alkoxysilane such as vinyltrimethoxysilane, vinyltriethoxysilane, or vinyltriisopropoxysilane; and an allyl- tri$C_{1-4}$alkoxysilane such as allyltrimethoxysilane or allyltriethoxysilane), a silane coupling agent having a (meth) acryloyl group (e.g., a (meth) acryloxy$C_{2-4}$alkyltri$C_{1-4}$alkoxysilane such as 2-(meth)acryloxyethyltrimethoxysilane, 3- (meth)acryloxypropyltrimethoxysilane, or 3-(meth)acryloxypropyltriethoxysilane; and a (meth)acryloxy$C_{2-4}$alkyl$C_{1-4}$alkyl- di$C_{1-4}$alkoxysilane such as 3-(meth)acryloxypropylmethyldimethoxysilane or 3-(meth)acryloxypropylmethyldiethoxysilane)], a silane coupling agent having a mercapto group (e.g., a mercapto$C_{2-4}$alkyltri$C_{1-4}$alkoxysilane such as 3-mercaptopropyltrimethoxysilane), and a silane coupling agent having a carboxyl group (e.g., a carboxy$C_{2-4}$alkyltri$C_{1-4}$alkoxy- silane such as 2-carboxyethyltrimethoxysilane).

These organic silicon compounds may be used alone or in combination. Among these organic silicon compounds, in the light of the improvement of the adhesion due to the action on the copolymer elastomer, a silane coupling agent and an alkoxysilane having an alkyl group are preferred; in particular, in the light of excellent reactivity or affinity to the copolymer elastomer, a silane coupling agent having a polymerizable group (e.g., a silane coupling agent having an ethylenic unsaturated bond group such as a vinyl group or a (meth)acryloyl group) and an alkyltri$C_{1-4}$alkoxysilane are preferred.

Along them, a silane coupling agent having a vinyl group or a (meth)acryloyl group is preferred in that the silane coupling agent has a reactivity to the copolymer elastomer and can improve the adhesion in a small quantity. In particular, a silage coupling agent having a (meth)acryloyl group is preferred in that the silane coupling agent can improve the adhesion in a small quantity. The reason the silane coupling agent having a (meth) acryloyl group improves the adhesion in a small quantity is not known. It is presumed that the silane coupling agent comes up to (is unevenly distributed on) the surface of the copolymer elastomer due to a polar group thereof in cooling for solidification of the polymer even if the copolymer elastomer and the silane coupling agent are melt-mixed uniformly. Further, according to the present invention, a silane coupling agent having an acryloyl group is particularly preferred in terms of improved uniform crosslinking in lamination due to a mild reactivity and stable mixing property thereof.

Moreover, an alkyltri$C_{1-4}$alkoxysilane and a silane coupling agent having an allyl group are preferred since these compounds are easily mixed to the copolymer elastomer uniformly due to an excellent compatibility with the copolymer elastomer and have excellent sheet-formability or stability. A $C_{4-12}$alkyltrialkoxysilane such as a hexyltri$C_{1-4}$alkoxysilane is particularly preferred.

The ratio of the organic silicon compound is, for example, about 0.01 to 20 parts by weight (e.g., about 0.1 to 10 parts by weight), preferably about 0.3 to 5 parts by weight, and more preferably about 0.5 to 3 parts by weight (particularly about 0.8 to 2 parts by weight) relative to 100 parts by weight of the copolymer elastomer. In particular, a silane coupling agent having a (meth) acryloyl group may be used in a small quantity. The ratio of the silane coupling agent having a (meth) acryloyl group is about not more than 3 parts by weight, preferably about 0.01 to 2 parts by weight, and more preferably about 0.01 to 1.5 parts by weight (particularly, about 0.01 to 1 parts by weight) relative to 100 parts by weight of the copolymer elastomer.

[Radical generator]

The photosemiconductor protective material of the present invention may further contain a radical generator in the case where the organic silicon compound or the after-mentioned crosslinking agent has a radical-polymerizable group. The radical generator can promote (or accelerate) the reaction of the organic silicon compound or the crosslinking agent. In addition, the reaction can be controlled by adjusting the half-life temperature depending on the working temperature of the photosemiconductor protective material.

The radical generator may include a conventional thermal radical generator, for example, an organic peroxide [e.g., a hydroperoxide (such as t-butyl hydroperoxide, 1,1,3,3-tetrabutyl hydroperoxide, t-amyl hydroperoxide, cumene hydroperoxide, or diisopropylbenzene hydroperoxide), a diacyl peroxide (such as dilauroyl peroxide or dibenzoylperoxide), an alkyl peroxy ester (such as t-butyl proxy acetate, t-butyl proxy benzoate, or t-amyl peroxybenzoate), a peroxy carbonate (such as t-butyl peroxy 2-ethylhexylcarbonate), a dialkyl peroxide (such as dicumylperoxide, 2,5-dimethyl-2,5-di(t-butylperoxy)hexane, 1,3-di(2-t-butylperoxyisopropyl)benzene, di-t-butyl peroxide, 2,5-dimethyl-2,5-di(t-butylperoxy)hexyne-3, or di-t-amyl peroxide), a peroxy ketal (such as ethyl-3,3-di(t-butylperoxy)butyrate), and a ketone peroxide (such as methyl ethyl ketone peroxide)], an inorganic peroxide (e.g., hydrogen peroxide, sodium persulfate, potassium persulfate, and ammonium persulfate) , an azo compound {e.g., 2,2'-azobisisobutyronitrile, 2,2'-azobis-2,4-dimethylvaleronitrile, 2,2'-azobis(2-amidinopropane) dihydrochloride, 2,2'-azobis[2-methyl-N-(2-hydroxyethyl)-propionamide], and 2,2'-azobis[2-(2-imidazolin-2-yl)propane]}. Moreover, the organic or inorganic peroxide may be used in combination with a reducing agent to form a redox polymerization initiator. The reducing agent may include, for example, L-ascorbic acid, L-sorbic acid, sodium metabisulfite, ferrous sulfate, and Rongalit.

Moreover, as the radical generator, a conventional photo radical generator may also be used. Examples of the photo radical generator may include a benzoin compound (e.g., benzoin, and a benzoin alkyl ether such as benzoin methyl ether, benzoin ethyl ether, or benzoin isopropyl ether), a phenyl ketone [for example, an acetophenone compound (e.g., acetophenone, 2-hydroxy-2-methyl-1-phenylpropan-1-one, 2,2-dimethoxy-2-phenylacetophenone, 2,2-diethoxy-2-phenylacetophenone, and 1,1-dichloroacetophenone); an alkyl phenyl ketone such as 2-hydroxy-2-methylpropiophenone; and a cycloalkyl phenyl ketone such as 1-hydroxycyclohexyl phenyl ketone], an aminoacetophenone {for example, 2-methyl-1-[4-(methylthio)phenyl]-2-morpholinoamino pro  panone-1,2-benzyl-2-dimethylamino-1-(4-morpholinopheny l)-butanone-1}, an anthraquinone compound (e.g., anthraquinone, 2-methylanthraquinone, 2-ethylanthraquinone, 2-t-butylanthraquinone, and 1-chloroanthraquinone), a thioxanthone compound (e.g., 2,4-dimethylthioxanthone, 2,4-diethylthioxanthone, 2-chlorothioxanthone, and 2,4-diisopropylthioxanthone), a ketal compound (e.g., acetophenone dimethyl ketal and benzyl dimethyl ketal), a benzophenone compound (e.g., benzophenone), a xanthone compound, and a phosphine oxide compound (e.g., 2,4,6-trimethylbenzoyldiphenylphosphine oxide). These photo radical generators may be used alone or in combination.

The photo radical generator may be used in combination with a photosensitizer. The photosensitizer may include a conventional component, for example, a tertiary amine [e.g., a trialkylamine, a trialkanolamine (e.g., triethanolamine), an alkyl dialkylaminobenzoate such as ethyl N,N-dimethylaminobenzoate or amyl N,N-dimethylaminobenzoate, and a bis(dialkylamino)benzophenone such as 4,4-bis(dimethylamino)benzophenone (Michler's ketone) or 4,4'-diethylaminobenzophenone], a phosphine compound such as triphenylphosphine, a toluidine compound such as N,N-dimethyltoluidine, and an anthracene compound such as 9,10-dimethoxyanthracene, 2-ethyl-9,10-dimethoxyanthracene, or 2-ethyl-9,10-diethoxyanthracene. The photosensitizers may be used alone or in combination.

These radical generators may be used alone or in combination. Among these radical generators, the thermal radical generator is widely used. Among them, a radical generator having a one-hour half-life temperature (a temperature at which the amount of active oxygen atoms of a radical generator is halved, by decomposition for one hour) higher than the melting point of the copolymer elastomer, (for example, a dialkyl peroxide) is preferred in the respect that the compound has a high capacity for generating a radical, is not decomposed at the melting temperature of the copolymer elastomer, and can be preserved at a room temperature for a long period of time to easily perform a crosslinking reaction after preparation of a sheet. In particular, a di($C_{1-6}$alkylperoxy)$C_{4-10}$alkane (such as 2,5-dimethyl-2,5-di(t-butylperoxy) hexane) is preferred in in the respect that the compound has a high capacity for generating a radical due to two oxygen-oxygen bonds (-OO-) in a molecule thereof.

The ratio of the radical generator is, for example, about 0.01 to 5 parts by weight, preferably about 0.03 to 4 parts by weight, and more preferably about 0.05 to 3 parts by weight (particularly, about 0.1 to 2 parts by weight) relative to 100 parts by weight of the copolymer elastomer.

[Crosslinking agent]

The photosemiconductor protective material of the present invention may further contain a crosslinking agent in order to impart a proper (or reasonable) elasticity to the protective material. As the crosslinking agent, a bifunctional or polyfunctional compound having a plurality (about 2 to 8) of polymerizable groups may be used. According to the present invention, the addition of the crosslinking agent to the protective material to be used as a solar cell encapsulant can maintain a proper hardness and shape of the encapsulant even if a module is used under a high temperature. This, the lowering of the cushion property due to softening or the deformation, expansion or contraction of the encapsulant having a sheet form can be prevented. Further, since the addition of the crosslinking agent allows a proper crosslinked structure to be imparted to the protective material depending on the cyclic olefin content of the copolymer elastomer, a proper plasticity can be imparted to the protective material.

Examples of the bifunctional compound may include an alkylene glycol di(meth)acrylate [e.g., a $C_{2-10}$alkylene glycol di(meth)acrylate such as ethylene glycol di(meth)acrylate, propylene glycol di(meth)acrylate, trimethylene glycol di(meth)acrylate, 1,4-butanediol di(meth)acrylate, neopentyl glycol di(meth)acrylate, 1,6-hexanediol di(meth)acrylate, or 1,9-nonanediol di(meth)acrylate], a polyalkylene glycol di(meth)acrylate [e.g., a poly$C_{2-4}$alkylene glycol di(meth)acrylate such as diethylene glycol di(meth)acrylate, triethylene glycol di(meth)acrylate, a polyethylene glycol di(meth)acrylate, dipropylene glycol di(meth)acrylate, tripropylene glycol di(meth)acrylate, a polypropylene glycol di(meth)acrylate, or a polytetramethylene glycol di(meth)acrylate], a polyhydric alcohol di(meth)acrylate [such as glycerin di(meth)acrylate, trimethylolpropanedi(meth)acrylate, or pentaerythritol di(meth)acrylate], a di(meth)acrylate having a crosslinked cyclic hydrocarbon group (such as tricyclodecanedimethanol di(meth)acrylate or adamantane di(meth)acrylate), a di(meth)acrylate of a $C_{2-4}$alkylene oxide adduct of a bisphenol compound [e.g., 2,2-bis(4-(meth)acryloyloxydiethoxyphenyl)propane, 2,2-bis(4-(meth)acryloyloxyethoxyphenyl)propane, and 2,2-bis(4-(meth)acryloxypolyethoxyphenyl)propane], and a divinyl compound (e.g., 1,5-hexadiene, 1,6-hexadiene, 5-vinyl-2-norbornene, diallyl fumarate, diallyl maleate, trimethylolpropane diallyl ether, diallyl phthalate, and divinylbenzene).

The polyfunctional (e.g., tri-to octa-functional) compound may include, for example, a polyhydric alcohol poly(meth)acrylate [e.g., glycerin tri(meth)acrylate, trimethylolpropane tri(meth)acrylate, trimethylolethane tri(meth)acrylate, pentaerythritol tri(meth)acrylate, pentaerythritol tetra(meth)acrylate, dipentaerythritol penta(meth)acrylate, and dipentaerythritol hexa(meth)acrylate], and a polyvinyl compound (e.g., triallyl isocyanurate, triallyl cyanurate, triallyl trimellitate, pentaerythritol triallyl ether, dipentaerythritol triallyl ether, triallyl phosphate, and triallylamine).

These crosslinking agents may be used alone or in combination. Among these crosslinking agents, in terms of the improvement of the crosslinking density, a tri- or more (e.g., tri- to hexa-functional) compound is preferred; examples of the compound may include a (di)pentaerythritol tri- to hexa(meth)acrylate such was pentaerythritol tri(meth)acrylate, pentaerythritol tetra(meth)acrylate, or dipentaerythritol hexa(meth)acrylate, and a triallyl compound such as triallyl (iso)cyanurate. In the light of excellent heat resistance, a tri- no tetra-functional nitrogen-containing cyclic compound (such as triallyl isocyanurate) is particularly preferred.

It is sufficient that the ratio of the crosslinking agent is not more than 5 parts by weight (0 to 5 parts by weight) relative to 100 parts by weight of the copolymer elastomer. For example, the ratio of the crosslinking agent relative to 100 parts by weight of the copolymer elastomer is about 0.01 to 5 parts by weight, preferably about 0.1 to 4 parts by weight, and more preferable about 0.3 to 3 parts by weight (particularly, about 0.5 to 2 parts by weight).

[Other additives]

The photosemiconductor protective material of the present invention may further contain a stabilizer such as an ultraviolet ray absorbing agent, a light stabilizer, an antioxidant, or a heat stabilizer. In particular, since the solar cell encapsulant is exposed to sunlight for a long period of time, the protective material containing a stabilizer (suck as an ultraviolet ray absorbing agent or a light stabilizer) is useful for the encapsulant.

The ultraviolet ray absorbing agent may include, for example, a salicylate-based ultraviolet ray absorbing agent such as phenyl salicylate or 2,4-di-t-butylphenyl-3,5-di-t-butyl-4-hydroxy benzoate; a benzotriazole-based ultraviolet ray absorbing agent such as 2-(2-hydroxy-5-methylphenyl)benzotriazole, 2-[2-hydroxy-3-(3,4,5,6-tetrahydrophthalimidemethyl)-5-methylphenyl]benzotriazole, 2-(3-t-butyl-2-hydroxy-5-methylphenyl)-5-chlorobenzotriazole, 2-(2-hydroxy-5-t-butylphenyl)benzotriazole, 2-(2-hydroxy-3,5-di-t-butylphenyl)benzotriazole, 2-(2-hydroxy-3,5-bis($\alpha,\alpha$-dimethylbenzyl)phenyl)benzotriazole, octyl-3-[3-t-butyl-4-hydroxy-(5-chloro-2H-benzotriazol -2-yl)phenyl]propionate, 2-(2H-benzotriazol-2-yl)-4,6-bis(1-methyl-1-phenylethyl)phenol, or 2-(2H-benzotriazol-2-yl)-6-(1-methyl-1-phenylethyl)-4-(1,1,3,3-tetramethylbutyl)phenol; a benzophenone-based ultraviolet ray absorbing agent such as 2-hydroxybenzophenone, 2-hydroxy-4-methoxybenzophenone, 2-hydroxy-4-octyloxybenzophenone, or 2,2'-dihydroxy-4-methoxybenzophenone; and a hydroxyphenyltriazine-based ultraviolet ray absorbing agent such as a reaction product of 2-(4,6-bis(2,4-dimethylphenyl)-1,3,5-triazin-2-yl)-5-hydroxyphenyl and oxirane, a reaction product of 2-(2,4-dihydroxyphenyl)-4,6-bis(2,4-dimethylphenyl)-1,3,5-triazine) and 2-ethylhexylglycidic acid ester, or 2,4-bis[2-hydroxy-4-butoxyphenyl]-6-(2,4-dibutoxyphenyl)-1,3,5-triazine.

The light stabilizer (HALS) may include a hindered amine compound, for example, 1,2-bis(2,2,6,6-tetramethyl-4-piperidyloxy)ethane, phenylnaphtylamine, N,N'-diphenyl-1,4-phenylenediamine, and N-phenyl-N'-cyclohexyl-1,4-phenylenediamine; a compound having a 2,2,6,6-tetramethylpiperidine skeleton or a 1,2,2,6,6-pentamethyl-4-piperidine skeleton, for Example, N,N',N'',N'''-tetrakis(4,6-bis(butyl(N-methyl-2,2,6,6-tetramethylpiperidin-4-yl)amino)triazin-2-yl)-4,7-diazadecane-1,10-diamine, decanedioic acid bis(2,2,6,6-tetramethyl-1-octyloxy-4-piperidinyloxy) ester, bis(1,2,2,6,6-pentamethyl-4-piperidinyl)[[3,5-bis (1,1-dimethylethyl)-4-hydroxyphenyl]methyl] butyl malonate, bis(1,2,2,6,6-pentamethyl-4-piperidinyl) sebacate, a $C_{4-20}$alkane-dicarboxylic acid ester corresponding to each of these dicarboxylic acid esters (such as a malonate or an adipate), and an arenedicarboxylic acid ester corresponding to each of these dicarboxylic acid. esters (such as a terephthalate).

Examples of the antioxidant may include a hindered phenol compound, for example, an alkylphenol antioxidant such as 2,6-di-t-butyl-p-cresol, 2,2'-methylenebis(4-methyl-6-t-butylphenol), 2,2'-thiobis(4-methyl-6-t-butylphenol); a $C_{10-35}$alkyl[3-(3,5-di-t-butyl-4-hydroxyphenyl)propionate] such as n-octadecyl[3-(3,5-di-t-butyl-4-hydroxyphenyl)propionate]; a $C_{2-10}$alkanediol-bis[3-(3,5-di-t-bubyl-4-hydroxyphenyl)propionate] such as 1,6-hexanediol-bis[3-(3,5-di-t-butyl-4-hydroxyphenyl)propionate]; an oxy$C_{2-4}$alkylenediol-bis[3-(3,5-di-t-butyl-4-hydroxyphenyl)propionate] such as triethylene glycol-bis[3-(3-t-butyl-5-methyl-4-hydroxyphenyl)propionate]; a $C_{3-8}$alkanetriol-tris[3-(3,5-di-t-butyl-4-hydroxyphenyl)propionate] such as glycerin-tris[3-(3,5-di-t-butyl-4-hydroxyphenyl)propionate]; a $C_{4-8}$alkylenetetraol-tetrakis[3-(3,5-di-t-butyl-4-hydroxyphenyl)propionate] such as pentaerythrirtol-tetrakis[3-(3,5-di-t-butyl-4-hydroxyphenyl)propionate];

and an N,N'-C$_{2-10}$alkylenebis(3,5-di-t-butyl-4-hydroxyhydrocinnamamide) such as N,N'-hexamethylenebis(3,5-di-t-butyl-4-hydroxyhydrocinnamamide).

The heat stabilizer may include, for example, a phosphorus-containing stabilizer (or a phosphoric acid ester)such as a phosphite stabilizer (e.g., a tris(branched alkylphenyl) phosphite such as tris(2,4-di-t-butylphenyl) phosphite, and a bis(alkylaryl)pentaerythritol diphosphite), a sulfur-containing heat stabilizer,, and a hydroxylamine-based heat stabilizer.

These stabilizers may be used alone or in combination of two or more components (for example, a combination of a light stabilizer and an antioxidant, and a combination of an ultraviolet ray absorbing agent, a light stabilizer and an antioxidant).

Since the photosemiconductor protective material of the present invention comprises the chain olefin-cyclic olefin copolymer elastomer, the decomposition of the stabilizer by light or heat is prevented even in a long-term use. Thus, the protective material has a high light resistance. Among the above-mentioned stabilizers, the stabilizer that effectively resists the decomposition may include an ultraviolet ray absorbing agent, particularly, a benzophenone-based ultraviolet ray absorbing agent, and other agents. Thus, in the present invention, the stabilizer may comprise a combination of two or more components containing particularly an ultraviolet ray absorbing agent. For example, a combination of an ultraviolet ray absorbing agent and a light stabilizer, and a combination of an ultraviolet ray absorbing agent, a light stabilizer and an antioxidant are preferred. In particular, a combination of an ultraviolet ray absorbing agent, a light stabilizer, an antioxidant and a heat stabilizer are preferred. In these combinations, relative to 100 parts by weight of the ultraviolet ray absorbing agent, the light stabilizer may be about 10 to 1000 parts by weight (particularly, about 100 to 300 parts by weight), the antioxidant may be about 10 to 500 parts by weight (particularly, about 50 to 200 parts by weight), the heat stabilizer may be about 10 to 300 parts by weight (particularly, about 20 to 50 parts by weight).

The ratio of each stabilizer is, for example, about 0.01 to 5 parts by weight, preferably about 0.05 to 3 parts by weight, and more preferably about 0.1 to 1 parts by weight (particularly, about 0.2 to 0.5 parts by weight) relative to 100 parts by weight of the copolymer elastomer. An excessively high ratio of the stabilizer tends to lowers various functions (e.g., light transmittance property, intensity, adhesion, and dampproofing property) of the photosemiconductor projective material. According to the present invention, however, since the decomposition of the stabilizer is prevented, and a small amount of the stabilizer allow a protecting function to be expressed for a long period of time. Thus, various functions of the protective material can also be expressed sufficiently.

The photosemiconductor protective material of the present invention may further contain a conventional additive, for example, a plasticizer, an antistatic agent, a flame retardant, a filler, a coloring agent, a lubricant, and a nucleation agent.

[Photosemiconductor protective material, precursor thereof, and process for producing the same]

The photosemiconductor protective material is obtainable by a melt-mixing a polymer composition at least containing a chain olefin-cyclic olefin copolymer elastomer and molding the composition. The protective material is not particularly limited to a specific shape (or form), and may be selected according to purposes. The shape of the protective material is usually in the form of a sheet or a film.

The melt-mixing method may be a conventional manner, for example, a method of providing the polymer composition in a conventional melt-mixer such as a monoaxial or biaxial extruder, a Banbury mixer, a kneader, or a mixing roller and melt-mixing the polymer composition. The melt-mixing temperature may for example be about 70 to 150°C, preferably about 80 to 130°C, and more preferably about 100 to 120°C. The mixing time is usually about 5 to 10 minutes. Depending on the mixer or mixing formulation, the mixing time may be selected suitably.

As the molding method, according to purposes, various conventional manners can be used, for example, an extrusion molding, an injection molding, a press molding, a blow molding, and a compression molding. In the case of molding the polymer composition into a sheet or a film, there may be used, for example, a press molding, an extrusion molding such as extrusion [e.g., a die (such as flat die, T-shaped on circular die) method, and an inflation method], a stretch method by a tenter manner, a tube manner, an inflation manner, or other manner. A widely used method includes a press molding, an extrusion, and the like.

The thickness of the sheet can be selected according to purposes. For example, the solar cell encapsulant has a thickness of about 0.1 to 5 mm, preferably about 0.2 to 3 mm, and more preferably about 0.3 to 2 mm (particularly, about 0.5 to 1 mm; The thickness may be selected depending on the size or structure of then solar cell, the process manner, and others.

In the photosemiconductor protective material containing a radical generator (further a silane coupling agent having a polymerizable group and/or a crosslinking agent), the melt-mixing temperature and the molding temperature may be adjusted to a temperature lower than the one-hour half-life temperature of the radical generator, for example, lower than 140°C, preferably not lower than 90°C to lower than 140°C, and more preferably about 100 to 130°C (particularly, about 100 to 120°C). The molded product (in particular, a sheet-shaped molded product) treated at such a temperature has the silane coupling agent having a polymerizable group and/or the crosslinking agent in an unreacted state and can be used as a precursor of a photosemiconductor protective material.

Among the photosemiconductor protective materials, an encapsulant or filler sheet (a precursor of an adhesive or encapsulant) as the solar cell encapsulant or filler is used to encapsulate a solar cell between a front glass and a back sheet by vacuum lamination of a stack of these members. The adhesion of the precursor (or encapsulant sheet) to the members (such as the solar cell, the front glass, or the back sheet) can be improved by performing the lamination at a temperature of not lower than the half-life temperature (e.g., not lower than 140°C, preferably about 140 to 200°C, and more preferably about 150 to 180°C).

The photosemiconductor protective material of the present invention may be crosslinked by irradiating a precursor containing a silane coupling agent having a polymerizable group and/or a crosslinking agent with light (e.g., ultraviolet ray) or electron beam (EB). In the case of electron beam Irradiation, the protective material may be free from a radical generator.

The photosemiconductor protective material of the present invention has excellent elasticity and softness (or flexibility) and has a storage modulus E' of, for example, about 30 to 300 MPa, preferably about 50 to 200 MPa, and more preferably about 60 to 180 MPa (particularly, about 80 to 150 MPa) at 25°C.

The photosemiconductor protective material of the present invention has an excellent transparency. In a method in accordance with JIS K7105 (0.5 mm thick), the photosemiconductor protective material has a total light transmittance of not less than 80%, preferably about 85 to 99%, and more preferably about 88 to 98% (particularly, about 90 to 95%) and a haze of not more than 30% (e.g., about 1 to 30%), preferably about 2 to 20% (e.g., about 3 to 15%) , and more preferably about 5 to 12% (particularly, about 6 to 9%).

The photosemiconductor protective material of the present invention has an excellent gas barrier property (in particular, a barrier property against water vapor) and may have a water-vapor permeability under an atmosphere at a temperature of 60°C and a humidity of 90%RH (per 100 $\mu$m thick) of, for example, not more than 100 g/m $^2$ ·day (e.g. , about 0.1 to 100 g/m$^2$·day), preferably not more than 80 g/m$^2$·day (e.g., 0.5 to 80 g/m$^2$ ·day), more preferably not more than 60 g/m$^2$·day (e.g., 1 to 60 g/m$^2$·day), and particularly, not more than 50 g/m$^2$·day (e.g., about 5 to 50 g/m$^2$·day.

The photosemiconductor protective material of the present invention has a high light resistance due to prevention of the decomposition of the ultraviolet ray absorbing agent (in particular, a benzophenone-based ultraviolet ray absorbing agent) as described above. Specifically, the protective material has a residual ratio of the ultraviolet ray absorbing agent of not less than 50%, preferably not less than 80% (e.g., about 80 to 99%), and more preferably about 85 to 98% (particularly, about 88 to 95%) after xenon lamp irradiation at an irradiance of 180 W/m$^2$ for 200 hours at black panel temperature (BPT) of $44\pm2$°C. The residual ratio of the ultraviolet ray absorbing agent can specifically be measured by a weather resistance tester according to a method described in Examples.

The protection form of the photosemiconductor with the photosemiconductor protective material of the present invention is not particularly limited to a specific one. The photosemiconductor (e.g., a solar cell) may be embedded in the protective material, or may be covered or sealed with the protective material sheet. In particular, in the case where the protective material is used as a solar cell encapsulant (or adhesive), at least one side of a solar cell may be covered with the encapsulant sheet (an encapsulant sheet or precursor) and encapsulated or sealed in the sheet by heat lamination. The solar cell may tightly be encapsulated (or filled) without leaving space by covering both sides of the solar cell with the encapsulant sheet (or sheets) and encapsulating the solar cell in the sheet (or sheets) by heat lamination. Specifically, since the solar cell encapsulant of the present invention has excellent melt-fluidity and adhesion, the encapsulant sheets on both sides of the solar cell can be united to encapsulate the cell, and can occlude gaps between cells or wires to protect the cells or wires effectively. The encapsulant sheet residing on a back (rear) side of the solar cell also functions as a back sheet due to a high gas barrier property of the encapsulant of the present invention, and a back sheet can be omitted.

EXAMPLES

The following examples are intended to describe this invention in further detail and should by no means be interpreted as defining the scope of the invention. The glass transition, temperature and melting point, haze, degree of crystallinity, tensile test, light resistance and hydrolysis resistance of a sheet constituting a soft layer, and the embossing quality of a lamination sheet were measured according to the after-mentioned methods.

(Glass transition temperature and melting point)

The glass transition temperature and the melting point were measured under a nitrogen flow at a heating rate of 10°C/minute by a differential scanning calorimeter (manufactured by Seiko Instruments & Electronics Ltd., "DSC6200").

(Total light transmittance and haze)

Each one of polymer sheets after heat lamination obtained in Examples and Comparative Examples was examined for the total light transmittance and haze as follows. The for the total light transmittance and haze as follows. The polymer sheet was pulverized. The pulverized powder was disposed on a first glass plate having a Teflon (registered trademark) spacer 0.5 mm high on all sides thereof, and a second glass plate was put on the first glass plate (that is, the pulverized powder was sandwiched between these glass plates) and was placed art 150 to 160°C for 20 to 40 minutes under a vacuum with the both glass plates pressed to produce a molten film. The film was allowed to cool to a room temperature and then taken out of the glass plates. The total light transmittance of the film and the haze thereof were measured by a haze meter (manufactured by Nippon Denshoku Industries Co., Ltd., NDH-500).

(Elastic modulus at room temperature)

Each one of polymer sheets after heat lamination obtained in Examples and Comparative Examples was examined for the elastic module at a room temperature as follows. The polymer sheet was subjected to temperature change from -50°C to 120°C by a solid viscoelasticity measuring apparatus (manufactured by TA Instruments Japan Inc.), and the elastic modulus at a room temperature was determined from a storage modulus E′ at 25°C.

(Barrier property against water vapor : coefficient of moisture permeability)

Each one of polymer sheets after heat lamination obtained in Example and Comparative Examples was examined for the barrier property against water vapor as follows. Calcium chloride was put in a container, and the container was sealed with the polymer sheet and allowed to strand in a hot and humid bath at 60°C and a humidity of 90%RH for 24 hours. Thereafter, the container was removed from the bath, and the water absorbed by calcium chloride in the container was measured according to a gravimetric method. The quantity of the permeated water vapor was calculated based on the effective area of the polymer sheet determined from the opening area of the container and the thickness of the sheet.

(Adhesion)

Each one of polymer sheets before heat lamination obtained in Examples and Comparative Examples was examined for the adhesion as follows. The polymer sheet was held between a glass substrate and a PET film (0.1 mm thick) with a clip, pressed at 100°C for 2 minutes by a vacuum laminator, and then heated to 180°C and maintained for 20 minutes for pressure and heat treatment. Thereafter, the resultant was allowed to stand at a room temperature to give a lamination product composed of the glass substrate/the polymer sheet/the PET film. Next, the polymer sheet and the PET film of the lamination product were bent back through an angle of 180° together and subjected to 180° tensile test in accordance with JIS K6854-2. The peel force measured at a tension rate of a 300 mm/minute was considered as an adhesive strength of the polymer sheet to the glass substrate.

(Light resistance (residual ratio of ultraviolet ray absorbing agent))

Each one of polymer sheets before heat lamination obtained in Examples 11 and 12 and Comparative Example 3 was examined for the light resistance as follows. The polymer sheet was held between two quartz glass substrates with a clip, pressed at 100°C for 2 minutes by a vacuum laminator, and then heated to 180°C and maintained for 20 minutes for pressure and heat treatment. Thereafter, the resultant was allowed to stand at a room temperature to give a lamination product composed of the quartz glass substrate/the polymer sheet/the quartz glass substrate. Next, the polymer sheet of the lamination product was subjected to a light resistance test (irradiance of 180 W/m$^2$, BUT temperature of 44±2°C, 200 hours, without water spray) by a weathering test instrument (manufactured by Suga Test Instruments Co., Ltd., "Super Xenon Weather Meter SX2"). Before and after this light resistance test, the ultraviolet and visible light transmittance of the lamination product was measured by a spectrophotometer (manufactured by Hitachi High-Technologies Corporation, "U-3900H"). Further, the residual ratio of the ultraviolet ray absorbing agent was calculated from a transmittance change in the characteristic absorption wavelength of the ultraviolet ray absorbing agent. Specifically, a benzophenone-based ultraviolet ray absorbing agent (manufactured by Tokyo Chemical Industry Co., Ltd., "2-hydroxy-4-octyloxybenzophenone") has a characteristic absorption wavelength of 328 nm. The transmittance of the lamination product in the characteristic absorption wavelength before and after the test was measured, and the absorptance was calculated from the formula: Absorptance A (%) = 100 (%) - Transmittance T (%). That is, the residual ratio of the ultraviolet ray absorbing agent was determined based on the absorptance before the test and was calculated based on the following formula:

$$Residual \ ratio \ (\%) \ = \ (A \div A_0) \ x \ 100$$

wherein $A_0$ represents an absorptance at 328 nm before the test, A represents an absorptance at 328 nm after the test.

(Weather resistance)

An encapsulated solar cell was produced according to the method described in Example 1 and subjected to thermal cycling test (-40°C to 85°C, 50 cycles) and humidity-freeze test (85°C, humidity 85% to -40°C, 10 cycles) in accordance with IEC 61215. The external appearance (encapsulated state) of the encapsulant sheet after the weather resistance test was visually observed, and the change of the power generation efficiency before and after the test was evaluated. When the decrease in power generation efficiency after the test is less than 5%, it is judged that the encapsulant sheet has a continuously usable weather resistance. When the decrease in power generation efficiency after the test is not less than 5%, it is judged that the encapsulant sheet cannot tolerate the test due to a poor weather resistance thereof and brakes down.

Production Example 1 (Ethylene-norbornene copolymer 1)

Into a 30-liter autoclave under a nitrogen atmosphere at a room temperature, 15 liters of toluene, 15 mmol of triisobutyl aluminum (TIBA), 0.75 mmol of zirconium tetrachloride, and 0.75 mmol of tetrakis (pentafluorophenyl) anilinium borate were put in this order, and then 1.5 liters of a toluene solution containing 70% bey weight of norbornene was added thereto. After the autoclave was heated to 50°C, the reaction was performed for 60 minutes while continuously introducing ethylene as to be an ethylene partial pressure of 5 kgf/cm$^2$. After the completion of the reaction, the resulting polymer solution was added to 15 liters of methanol to be precipitated. The polymer was filtered and dried to give an ethylene-norbornene copolymer 1. The yield was 3.58 kg, and the polymerization activity was 52 kg/gZr (yield per gram of zirconium).

From the $^{13}$C-NMR measurement of the ethylene-norbornene copolymer 1, the norbornene content was determined to be 7.3% by mol from the ratio of the sum of a peak based on an ethylene unit and peaks based on methylenes at 5- and 6-positions of a norbornene unit (near 30 ppm) relative to a peak based on a methylene group at 7-position of a norbornene unit (near 32.5 ppm). The glass transition temperature and the melting point of the ethylene-norbornene copolymer 1 measured by a differential scanning calorimeter were 0.5°C and 90°C, respectively.

Production Example 2 (Ethylene-norbornene copolymer 2)

Ethylene and norbornene were copolymerized in the same manner as in Production Example 1 except that 0.75 mmol of bis(cyclopentadienyl)dichlorozirconium was used instead of zirconium tetrachloride in Production Example 1. The resulting ethylene-norbornene copolymer 2 had a norbornene content of 10% by mol, a glass transition temperature of 2.0°C, and a melting point of 81°C.

Example 1

Into a laboplastmill (manufactured by Toyo Seiki Seisaku-sho, Ltd.), 100 parts by weight of the ethylene-norbornene copolymer obtained in Production Example 1, 0.3 parts by weight of a hindered amine-based light stabilizer (manufactured by Ciba Japan K.K., "TINUVIN 622LD"), and 0.3 parts by weight of a hindered phenol-based antioxidant (manufactured by Ciba Japan K.K., "IRGANOX 1010") were put, and these components were kneaded at a temperature of 100 to 120°C for 5 minutes to give a polymer composition.

The melt viscosity of the resulting polymer composition was measured by a viscoelasticity measuring apparatus (manufactured by Nihon SiberHegner K.K.) while maintaining a temperature of 130 to 180°C. The viscosity was decreased from 2 x 10$^7$ Pa at the start of melting (100°C) to 2 x 10$^4$ Pa at 150°C. This means that the polymer composition has an excellent lamination workability in solar cell module production.

The resulting polymer composition was pressed at 100°C and 10 MPa for 5 minutes by a compression-molding pressing machine (manufactured by Toyo Seiki Seisaku-sho, Ltd., "Mini Test Press-10") to form a polymer sheet having a thickness of about 0.7 mm. A glass substrate, the resulting polymer sheet (encapsulant), a solar cell, the resulting polymer sheet (encapsulant), a glass substrate were stacked in this order and held by a vacuum laminator at 150 to 180°C for 20 to 40 minutes to give an encapsulated solar cell. The resulting polymer sheet has uniform and excellent optical properties and proper softness (or flexibility) as a solar cell module encapsulant sheet. This, the sheet was suitable to give a solar cell module having a lamination of the sheet(s) and other members.

Example 2

A polymer sheet was produced in the same manner as in Example 1 except that the ethylene-norbornene copolymer obtained in Production Example 2 was used as the ethylene-norbornene copolymer and that the kneading time ways 10 minutes, and then an encapsulated solar cell was produced in the same manner as in Example 1. The resulting polymer sheet was suitable as a solar cell module encapsulant sheet as in the case of Example 1.

Example 3

A polymer sheet was produced in the same manner as in Example 1 except that 100 parts by weight of the ethylene-norbornene copolymer obtained in Production Example 2, 0.1 parts by weight of 2,5-dimethyl-2,5-di(t-butylperoxy)hexane (manufactured by Arkema Yoshitomi, Ltd., "Luperox 101"), 0.1 parts by weight of 3-acryloxypropyltrimethoxysilane (manufactured by Tokyo Chemical Industry Co., Ltd.), 0.3 parts by weight of a hindered amine-based light stabilizer (TINUVIN 622LD), and 0.3 parts by weight of a hindered phenol-based antioxidant (IRGANOX 1010) were put into the laboplastmill, and then an encapsulated solar cell was produced in the same manner as in Example 1. The resulting polymer sheet was suitable as a solar cell module encapsulant sheet as in the case of Example 1.

Example 4

A polymer sheet was produced in the same manner as in Example 1 except that 100 parts by weight of the ethylene-norbornene copolymer obtained in Production Example 2, 1 part by weight of triallyl isocyanurate (manufactured by Tokyo Chemical Industry Co., Ltd.), 1 part by weight of 2,5-dimethyl-2,5-di(t-butylperoxy)hexane (Luperox 101), 1 part by weight of 3-acryloxypropyltrimethoxysilane, 0.3 parts by weight of a hindered amine-based light stabilizer (TINUVIN 622LD), and 0.3 parts by weight of a hindered phenol-based antioxidant (IRGANOX1010) were put into the laboplastmill, and then an encapsulated solar cell was produced in the same manner as in Example 1. The resulting polymer sheet was suitable as a solar cell module encapsulant sheet as in the case of Example 1.

Example 5

A polymer sheet was produced in the same manner as in Example 1 except that 100 parts by weight of the ethylene-norbornene copolymer obtained in Production Example 2, 0.1 parts by weight of triallyl isocyanurate, 0.1 parts by weight of 2,5-dimethyl-2,5-di(t-butylperoxy)hexane (Luperox 101), 0.1 parts by weight of 3-acryloxypropyltrimethoxysilane, 0.3 parts by weight of a hindered amine-based light stabilizer (TINUVIN 622LD), and 0.3 parts by weight of a hindered phenol-based antioxidant (IRGANOX 1010) were put into the laboplastmill, and then an encapsulated solar cell was produced in the same manner as in Example 1. The resulting polymer sheet was suitable as a solar cell module encapsulant sheet as in the case of Example 1. Moreover, the encapsulant sheet after the weather resistance test had only one peeled site. Further, the cell after the weather resistance test had a power generation efficiency of 11.6% and a power decreasing rate of 0.1%. That is, the evaluation of weather resistance was good, "B".

Example 6

A polymer sheet was produced in the same manner as in Example 1 except that 100 parts by weight of the ethylene-norbornene copolymer obtained in Production Example 1, 2 parts by weight of triallyl isocyanurate, 1 part by weight of 2,5-dimethyl-2,5-di(t-butylperoxy)hexane (Luperox 101), 5 parts by weight of 3-acryloxypropyltrimethoxysilane, 0.3 parts by weight of a hindered amine-based light stabilizer (TINUVIN 622LD), and 0.3 parts by weight of a hindered phenol-based antioxidant (IRGANOX 1010) were put into the laboplastmill, and then an encapsulated solar cell was produced in the same manner as in Example 1. The resulting polymer sheet was suitable as a solar cell module encapsulant sheet as in the case of Example 1. Moreover, the external appearance of encapsulant sheet after the weather resistance test had no peeled site. Further, the cell after the weather resistance test had a power generation efficiency of 11.9% and a power decreasing rate of less than 0.1%. That is, the evaluation of weather resistance was excellent, "A".

Example 7

A polymer sheet was produced in the same manner as in Example 4 except that 1 part by weight of pentaerythritol tetracrylate (manufactured by DAICEL-CYTEC Company, Ltd.) was used instead of triallyl isocyanurate as a crosslinking agent, and then an encapsulated solar cell was produced in the same manner as in Example 4. The resulting polymer sheet was suitable as a solar cell module encapsulant sheet as in the case of Example 1.

Example 8

A polymer sheet was produced in the same manner as in Example 4 except that 1 part by weight of 1,6-heptadiene (manufactured by Tokyo Chemical Industry Co., Ltd.) was used instead of triallyl isocyanurate as a crosslinking agent, and then an encapsulated solar cell was produced in the same manner as in Example 4. The resulting polymer sheet was suitable as a solar cell module encapsulant sheet as in the case of Example 1.

Example 9

A polymer sheet was produced in the same manner as in Example 3 except that 0.1 parts by weight of n-hexyltrimethoxysilane (manufactured by Toray Dow Corning Co. Ltd.) were used instead of 3-acryloxypropyltrimethoxysilane, and then an encapsulated solar cell was produced in the same manner as in Example 3. The resulting polymer sheet was suitable as a solar cell module encapsulant sheet as in the case of Example 1.

Example 10

A polymer sheet was produced in the same manner as in Example 4 except that the amount of 2,5-dimethyl-2,5-di(t-butylperoxy)hexane (Luperox 101) was 0.1 parts by weight and that 0.1 parts by weight of n-hexyltrimethoxysilane was used instead of 3-acryloxypropyltrimethoxysilane, and then an encapsulated solar cell was produced in the same manner as in Example 4. The resulting polymer sheet was suitable as a solar cell module encapsulant sheet as in the case of Example 1.

Example 11

A polymer sheet was produced in the same manner as in Example 1 except that 100 parts by weight of the ethylene-norbornene copolymer obtained in Production Example 2, 1.0 part by weight of 2,5-dimethyl-2,5-di(t-butylperoxy)hexane (Luperox 101), 0.1 parts by weight of 3-acryloxypropyltrimethoxysilane, 0.5 parts by weight of a hindered amine-based light stabilizer (TINUVIN 622LD), 0.3 parts by weigh of a hindered phenol-based antioxidant (IRGANOX 1010), 0.1 parts by weight of a phosphite-based heat stabilizer (manufactured by Ciba Japan K.K., "Irgafos 168"), and 0.3 parts by weight of a benzophenone-based ultraviolet ray absorbing agent (manufactured by Tokyo Chemical Industry Co., Ltd., "2-hydroxy-4-octyloxybenzophenone") were put into the laboplastmill, and then an encapsulated solar cell was produced in the same manner as in Example 1. The resulting polymer sheet was suitable as a solar cell module encapsulant sheet as in the case of Example 1. Moreover, the polymer sheet before heat lamination for an encapsulated cell was subjected to the light resistance test, and the residual ratio of the ultraviolet ray absorbing agent 100 hours and 200 hours after the test was measured. The results are shown in Fig. 3.

Example 12

A polymer sheet was produced in the same manner as in Example 1 except that 100 parts by weight of the ethylene-norbornene copolymer obtained in Production Example 2, 1.0 part by weight of 2,5-dimethyl-2,5-di(t-butylperoxy)hexane (Luperox 101), 0.1 parts by weight of 3-acryloxypropyltrimethoxysilane, 0.5 parts by weight of a hindered amine-based light stabilizer (TINUVIN 770), 0.3 parts by weight of a hindered phenol-based antioxidant (IRGANOX 1010), 0.1 parts by weight of a phosphite-based heat stabilizer (Irgafos 168), and 0.3 parts by weight of a benzophenone-based ultraviolet ray absorbing agent (2-hydroxy-4-octyloxybenzophenone) were put into the laboplastmill, and then an encapsulated solar cell was produced in the same manner as in Example 1. The resulting polymer sheet was suitable as a solar cell module encapsulant sheet as in the case of Example 1. Moreover, the polymer sheet before heat lamination for an encapsulated cell was subjected to the light resistance test, and the residual ratio of the ultraviolet ray absorbing agent 100 hours and 200 hours after the test was measured. The results are shown in Fig. 3.

Comparative Example 1

Into a laboplastmill (manufactured by Toyo Seiki Seisaku-sho, Ltd.), 100 parts by weight of a low-density polyethylene (LDPE) (manufactured by Sumitomo Chemical L Company, Ltd., "SUMIKATHENE-L GA804"), 0.3 parts by weight of a hindered amine-based light stabilizer (TINUVIN 622LD), 0.3 parts by weight of a hindered phenol-based antioxidant (IRGANOX 1010) were put, and these components were kneaded at a temperature of 180 to 210°C for 10 minutes to give a polymer composition.

The resulting polymer composition was pressed at 200°C and 10 MPa for 5 minutes by a compression-molding pressing mashine (manufactured by Toyo Seiki Seisaku-sho, Ltd., "Mini Test Press-10") to form a polymer sheet having a thickness of about 0.7 mm. The resulting polymer sheet had an excellent barrier property against water vapor while the sheet had at insufficient light transmittance and a large haze. Moreover, compared with the polymer composition obtained from the ethylene-norbornene copolymer, the resulting polymer composition had a low elastic modulus and a low softness (or flexibility) and was inferior in a cushion property necessary for protecting a glass substrate or a solar cell. Further, the resulting polymer composition had a high melt viscosity and was difficult to process in lamination for a solar cell encapsulation.

Comparative Example 2

Into a laboplastmill (manufactured by Toyo Seiki Seisaku-sho, Ltd.), 100 parts by weight of a low-density polyethylene (manufactured by Sumitomo Chemical Company, Ltd., "SUMIKATHENE-L GA804"), 2 parts by weight of triallyl isocyanurate (manufactured by Tokyo Chemical Industry Co., Ltd.), 1 part by weight of 2,5-dimethyl-2,5-di(t-butylperoxy)hexane (Luperox 101), 5 parts by weight of 3-acryloxypropyltrimethoxysilane, 0.3 parts by weight of a hindered amine-based light stabilizer (TINUVIN 622LD), and 0.3 parts by weight of a hindered phenol-based antioxidant (IRGANOX 1010) were put, and these components were kneaded at a temperature of 180 to 210°C for 10 minutes to give a polymer composition.

The resulting polymer composition was pressed at 200°C and 10 MPa for 5 minutes by a compression-molding pressing machine (manufactured by Toyo Seiki Seisaku-sho, Ltd., "Mini Test Press-10") to form a polymer sheet having a thickness of about 0.7 mm. The resulting polymer sheet was uniform, while the polymer sheet had various properties at only the same level as those of Comparative Example 1. Thus, the sheet was not suitable to give a solar cell module having a lamination of the sheet(s) and other members.

Comparative Example 3

Into a laboplastmill (manufactured by Toyo Seiki Seisaku-sho, Ltd.), 100 parts by weight of an ethylene-vinyl acetate copolymer (EVA) (manufactured by Tosoh Corporation, "ULTRATHENE 751", vinyl acetate content: 28%), 0.1 parts by weight of triallyl isocyanurate, 1.0 parts by weight of 2,5-dimethyl-2,5-di(t-butylperoxy)hexane, 0.1 parts by weight of 3-acryloxypropyltrimethoxysilane, 0.5 parts by weight of a hindered amine-based light stabilizer (TINUVIN 770), 0.3 parts by weight of a hindered phenol-based antioxidant (IRGANOX 1010), 0.1 parts by weight of a phosphite-based heat stabilizer (Irgafos 168), and 0.3 parts by weight of a benzophenone-based ultraviolet ray absorbing agent (2-hydroxy-4-octyloxybenzophenone) were put, and these components were kneaded at a temperature of 70 to 100°C for 10 minutes to give a polymer composition.

The resulting polymer composition was pressed at 90°C and 10 MPa for 5 minutes by a compression-molding pressing machine (manufactured by Toyo Seiki Seisaku-sho, Ltd., "Mini Test Press-10") to form a polymer sheet having a thickness of about 0.7 mm. The resulting polymer sheet had an optical property, an elastic modulus at room temperature and adhesion strength almost the same level of those in Example 1 to 12, while the polymer sheet had a poor barrier property against water vapor, a lowered residual ratio of the ultraviolet ray absorbing agent, and a poor weather resistance. Thus, the sheet was not suitable as a solar cell module encapsulant sheet. Moreover, the polymer sheet before heat lamination for an encapsulated cell was subjected to the light resistance test, and the residual ratio of the ultraviolet ray absorbing agent 100 hours and 200 hours after the test was measured. The results are shown in Fig. 3.

Tables 1 and 2 show the formulation of the sheets produced in Examples and Comparative Examples. Table 3 shows the evaluation of the sheets obtained in Examples and Comparative Examples.

[Table 1]

Table 1

| | Polymer component (parts by weight) | Organic silicon compound (parts by weight) | Initiator (parts by weighty) | Crosslinking agent (parts by weight) |
|---|---|---|---|---|
| Example 1 | Elastomer 1:100 | - | - | - |
| Example 2 | Elastomer 2:100 | - | - | - |

(continued)

|  | Polymer component (parts by weight) | Organic silicon compound (parts by weight) | Initiator (parts by weighty) | Crosslinking agent (parts by weight) |
|---|---|---|---|---|
| Example 3 | Elastomer 2:100 | Acryloxypropyltrimethoxysilane:0.1 | 0.1 | - |
| Example 4 | Elastomer 2:100 | Acryloxypropyltrimethoxysilane:1 | 1 | Triallyl isocyanurate:1 |
| Example 5 | Elastomer 2:100 | Acryloxypropyltrimethoxysilane:0.1 | 0.1 | Triallyl isocyanurate:0.1 |
| Example 6 | Elastomer 1:100 | Acryloxypropyltrimethoxysilane:6 | 1 | Triallyl isocyanurate:2 |
| Example 7 | Elastomer 2:100 | Acryloxypropyltrimethoxysilane:1 | 1 | Pentaerythritol hexacrylate:1 |
| Example 8 | Elastomer 2:100 | Acryloxypropyltrimethoxysilane:1 | 1 | 1,6-Heptadiene:1 |
| Example 9 | Elastomer 2:100 | Hexyltrimethoxysilane:0.1 | 0.1 | - |
| Example 10 | Elastomer 2:100 | Hexyltrimethoxysilane:0.1 | 0.1 | Triallyl isocyanurate:1 |
| Example 11 | Elastomer 2:100 | Acryloxypropyltrimethoxysilane:0.1 | 1 | - |
| Example 12 | Elastomer 2:100 | Acryloxypropyltrimethoxysilane:0.1 | 1 | - |
| Comparative Example 1 | LDPE:100 | - | - | - |
| Comparative Example 2 | LDPE:100 | Acryloxypropyltrimethoxysilane:0.1 | 0.1 | Triallyl isocyanurate:0.1 |
| Comparative Example 3 | EVA:100 | Acryloxypropyltrimethoxysilane:0.1 | 0.1 | Triallyl isocyanurate:0.1 |

[Table 2]

Table 2

|  | UV-absorbing agent (parts by weight) | Light stabilizer (parts by weight) | Antioxidant (parts by weight) | Heat stabilizer (parts by weight) |
|---|---|---|---|---|
| Example 1 | - | TINUVIN 622LD:0.3 | 0.3 | - |
| Example 2 | - | TINUVIN 622LD:0.3 | 0.3 | - |
| Example 3 | - | TINUVIN 622LD:0.3 | 0.3 | - |
| Example 4 | - | TINUVIN 622LD:0.3 | 0.3 | - |
| Example 5 | - | TINUVIN 622LD:0.3 | 0.3 | - |
| Example 6 | - | TINUVIN 622LD:0.3 | 0.3 | - |
| Example 7 | - | TINUVIN 622LD:0.3 | 0.3 | - |
| Example 8 | - | TINUVIN 622LD:0.3 | 0.3 | - |
| Example 9 | - | TINUVIN 622LD:0.3 | 0.3 | - |

(continued)

|  | UV-absorbing agent (parts by weight) | Light stabilizer (parts by weight) | Antioxidant (parts by weight) | Heat stabilizer (parts by weight) |
|---|---|---|---|---|
| Example 10 | - | TINUVIN 622LD:0.3 | 0.3 | - |
| Example 11 | 0.3 | TINUVIN 622LD:0.5 | 0.3 | 0.1 |
| Example 12 | 0.3 | TINUVIN 770:0.5 | 0.3 | 0.1 |
| Comparative Example 1 | - | TINUVIN 622LD:0.3 | 0.3 | - |
| Comparative Example 2 | - | TINUVIN 622LD:0.3 | 0.3 | - |
| Comparative Example 3 | 0.3 | TINUVIN 770:0.5 | 0.3 | 0.1 |

[Table 3]

Table 3

| | Total light transmittance (%) | Haze (%) | Elastic modulus at room temperature (MPa) | Barrier property against water (g/(100μm·m²·day)) | Adhesion strength (N/cm) | Residual ratio of UV-absorbing agent (%) | Weather resistance |
|---|---|---|---|---|---|---|---|
| Example 1 | 91 | 23.5 | 90 | 27 | - | - | - |
| Example 2 | 91 | - | - | - | - | - | - |
| Example 3 | 91 | 11.8 | - | 30 | 30 | - | - |
| Example 4 | 91 | 9.5 | - | 35 | 70 | - | - |
| Example 5 | 91 | 10.3 | - | 30 | 40 | - | B |
| Example 6 | 92 | 8.9 | 94 | 40 | 160 | - | A |
| Example 7 | 92 | 9.1 | - | 35 | 60 | - | - |
| Example 8 | 92 | 9.2 | - | 35 | 50 | - | - |
| Example 9 | 92 | 9.6 | - | 30 | 40 | - | - |
| Example 10 | 91 | 9.0 | - | 32 | 40 | - | - |
| Example 11 | 91 | 7.7 | - | - | - | 90 | - |
| Example 12 | 91 | 7.9 | - | - | - | 88 | - |
| Comparative Example 1 | 90 | 75 | 340 | 20 | - | - | - |
| Comparative Example 2 | 90 | 78 | 380 | 40 | 150 | - | - |
| Comparative Example 3 | 93 | 1.9 | 22 | 565 | 126 | 43 | - |

As apparent from the results described in Table 3, the sheets of Examples have excellent optical property, elasticity, and barrier property against water vapor; in particular, the sheets of Examples 4 to 10 also have an excellent adhesion. In contrast, the sheets of Comparative Examples 1 to 2 have too high haze and elasticity, and the sheet of Comparative Example 3 is inferior in a barrier property against water vapor. Moreover, the solar cells having the polymer sheet obtained in each one of Examples 5 and 6 has an excellent external appearance of the encapsulant and no lowering of the power generation efficiency before and after the thermo cycle test and the humidity-freeze test, and these sheets have a high protective function for a photosemiconductor. Fig. 3 is a graph showing the light resistance of the ultraviolet ray absorbing agent; a higher residual ratio of the ultraviolet ray absorbing agent indicates that the light resistance of the polymer sheet at the initial stage of the start of use is maintained. As apparent from the results shown in Fig. 3, in the quartz glass lamination product, which transmits an ultraviolet ray, the significant decrease of the ultraviolet ray absorbing agent was observed in a short period of time for the encapsulant including the ethylene-vinyl acetate copolymer of Comparative Example 3, while the slight decrease of the ultraviolet ray absorbing agent was observed for Example 11 and 12. Further, the photosemiconductor protective material on the present invention has a high weather resistance also in the light of an excellent barrier property; against water vapor thereof.

INDUSTRIAL APPLICABILITY

The photosemiconductor protective material of the present invention is used as a photosemiconductor protective material for a solar cell device, a light emitting diode (LED), an inorganic or organic EL device, and other devices. In particular, the protective material is effectively usable as an encapsulant (or a filler) for a thin-film solar cell (in particular, a solar cell module) provided with a solid cell (such as crystalline or amorphous silicon, gallium-arsenide, copper-indium-gallium-selenium, or cadmium-tellurium) or an encapsulant (or a filler) having a back sheet function.

DESCRIPTION OF REFERENCE NUMERALS

1 ... Solar cell module
2 ... Front glass
3 ... Encapsulant
3a, 3b ... Encapsulant precursor (encapsulant sheet)
4 ... Solar cell
5 ... Back sheet

**Claims**

1.    A photosemiconductor protective material, comprising a chain olefin-cyclic olefin copolymer elastomer comprising a chain olefin and a cyclic olefin as polymerizable component.

2.    A photosemiconductor protective material according to claim 1, wherein the chain olefin-cyclic olefin copolymer elastomer comprises an $\alpha$-chain $C_{2-4}$olefin and a polycyclic olefin as the polymerizable components, and the molar ratio of the $\alpha$-chain $C_{2-4}$olefin relative to the polycyclic olefin is 80/20 to 99/1 in a ratio of the former/the letter.

3.    A photosemiconductor protective material according to claim 1 or 2, wherein the chain olefin-cyclic olefin copolymer elastomer has a degree of crystallinity of not higher than 20%, a glass transition temperature of not higher than 30°C, and a storage modules E' of 50 to 200 MPa at 25°C.

4.    A photosemiconductor protective material according to any one of claims 1 to 3, which further comprises an organic silicon compound having a hydrolytically condensable group.

5.    A photosemiconductor protective material according to claim 4, wherein the organic silicon compound comprises at least one member selected from the group consisting of an alkyltri$C_{1-4}$alkoxysilane, a silane coupling agent having a vinyl group, and a silane coupling agent having a (meth) acryloyl group.

6.    A photosemiconductor protective material according to claim 4, wherein the organic silicon compound comprises a silane coupling agent having a (meth) acryloyl group.

**7.** A photosemiconductor protective material according to any one of claims 4 to 6, wherein the ratio of the organic silicon compound is 0.01 to 20 parts by weight relative to 100 parts by weight of the chain olefin-cyclic olefin copolymer elastomer.

**8.** A photosemiconductor protective material according to any one of claims 1 to 7, which further comprises a radical generator.

**9.** A photosemiconductor protective material according to claim 8, wherein the radical generator has a one-hour half-life temperature higher than a melting point of the chain olefin-cyclic olefin copolymer elastomer.

**10.** A photosemiconductor protective material according to claim 8 or 9, wherein the ratio of the radical generator is 0.01 to 5 parts by weight relative to 100 parts by weight of the chain olefin-cyclic olefin copolymer elastomer.

**11.** A photosemiconductor protective material according to any one of claims 1 to 10 , which further comprises a crosslinking agent.

**12.** A photosemiconductor protective material according to claim 11, wherein the crosslinking agent has not less than 2 vinyl groups in a molecule thereof.

**13.** A photosemiconductor protective material according to claim 11 or 12, wherein the ratio of the crosslinking agent is 0.01 to 5 parts by weight relative to 100 parts by weight of the chain olefin-cyclic olefin copolymer elastomer.

**14.** A photosemiconductor protective material according to any one of claims 1 to 13, which further comprises an ultraviolet ray absorbing agent.

**15.** A photosemiconductor protective material according to claim 14, which has a residual ratio of the ultraviolet ray absorbing agent of not less than 80% after xenon lamp irradiation at an irradiance of 180 W/m$^2$ for 200 hours at a black panel temperature of $44 \pm 2$°C.

**16.** A photosemiconductor protective maternal according to any one of claims 1 to 15, which has a storage modulus E' of 50 to 200 MPa at 25°C.

**17.** A photosemiconductor protective material according to any one of claims 1 to 16, which has a haze of not more than 20% in a method (0.5 mm thick) in accordance with JIS K7105.

**18.** A photosemiconductor protective material according to any one of claims 1 to 17, which is an encapsulant or filler for a solar cell.

**19.** A precursor of a photosemiconductor protective material, which is a melt-kneaded product of a polymer composition comprising:

a chain olefin-cyclic olefin copolymer elastomer comprising a chain olefin and a cyclic olefin as polymerizable components and
at least one member selected from the group consisting of a silane coupling agent having a polymerizable group and a radical generator.

**20.** A precursor according to claim 19, which is obtainable by melt-kneading the polymer composition at a melting temperature lower than a one-hour half-life temperature of the radical generator.

**21.** A precursor according to claim 19 or 20, which is in the form of a sheet.

**22.** A process for producing a photosemiconductor protective material, comprising:

treating a precursor recited in any one of claims 19 to 21 with heat or an actinic ray.

**23.** A process according to claim 22, wherein the treatment with heat is carried out at a temperature not lower than a one-hour half-life temperature of the radical generator.

**24.** A solar cell module provided with an encapsulant or filler recited in claim 18, which is free from a back sheet.

**25.** A method of using a protective material for protecting a photosemiconductor, the projective material comprising a chain olefin-cyclic olefin copolymer elastomer comprising a chain olefin and a cyclic olefin as polymerizable components.

**26.** A method of using a precursor recited in any one of claims 19 to 21 as a photosemiconductor protective material.

Fig. 1

Fig. 2

Fig. 3

Light resistance of
UV-absorbing agent

Residual ratio of
UV-absorbing agent [%]

100.0
90.0
80.0
70.0
60.0
50.0
40.0

— ● —Ex. 11
——Ex. 12
····◆····Com. Ex. 3

0 hours            100 hours           200 hours

Xenon lamp irradiation time

<table>
<tr><td colspan="2" align="center"><strong>INTERNATIONAL SEARCH REPORT</strong></td><td colspan="2">International application No.<br><br>PCT/JP2011/059217</td></tr>
<tr><td colspan="4">A. CLASSIFICATION OF SUBJECT MATTER<br><em>H01L31/042</em>(2006.01)i, <em>C08F210/00</em>(2006.01)i, <em>C08F232/00</em>(2006.01)i,<br><em>H01L33/56</em>(2010.01)i<br><br>According to International Patent Classification (IPC) or to both national classification and IPC</td></tr>
<tr><td colspan="4">B. FIELDS SEARCHED</td></tr>
<tr><td colspan="4">Minimum documentation searched (classification system followed by classification symbols)<br>H01L31/042, C08F210/00, C08F232/00, H01L33/56</td></tr>
<tr><td colspan="4">Documentation searched other than minimum documentation to the extent that such documents are included in the fields searched<br>    Jitsuyo Shinan Koho       1922-1996   Jitsuyo Shinan Toroku Koho   1996-2011<br>    Kokai Jitsuyo Shinan Koho   1971-2011   Toroku Jitsuyo Shinan Koho   1994-2011</td></tr>
<tr><td colspan="4">Electronic data base consulted during the international search (name of data base and, where practicable, search terms used)</td></tr>
</table>

C. DOCUMENTS CONSIDERED TO BE RELEVANT

| Category* | Citation of document, with indication, where appropriate, of the relevant passages | Relevant to claim No. |
|---|---|---|
| X<br><br>Y | JP 2006-253427 A (Mitsui Chemicals, Inc.),<br>21 September 2006 (21.09.2006),<br>paragraphs [0005], [0026], [0027], [0046] to<br>[0054]<br>(Family: none) | 1,4-17,<br>19-23,25,26<br>2,3 |
| X<br><br>Y | JP 2-31451 A (Mitsui Petrochemical Industries,<br>Ltd.),<br>01 February 1990 (01.02.1990),<br>entire text; all drawings<br>(Family: none) | 1,4-17,<br>19-23,25,26<br>2,3 |
| Y | JP 5-261875 A (Idemitsu Kosan Co., Ltd.),<br>12 October 1993 (12.10.1993),<br>paragraphs [0004] to [0014], [0018], [0019]<br>(Family: none) | 2,3 |

☒ Further documents are listed in the continuation of Box C.    ☐ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search<br>    08 June, 2011 (08.06.11) | Date of mailing of the international search report<br>    21 June, 2011 (21.06.11) |
|---|---|
| Name and mailing address of the ISA/<br>    Japanese Patent Office | Authorized officer |
| Facsimile No. | Telephone No. |

Form PCT/ISA/210 (second sheet) (July 2009)

**INTERNATIONAL SEARCH REPORT**

International application No.

PCT/JP2011/059217

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2002-265890 A  (Idemitsu Petrochemical Co., Ltd.), 18 September 2002 (18.09.2002), paragraph [0012] (Family: none) | 3,16 |
| A | JP 2007-103738 A  (Mitsui Chemicals, Inc.), 19 April 2007 (19.04.2007), paragraphs [0027] to [0032] (Family: none) | 4-10,19-23 |
| A | JP 2010-59259 A  (Sekisui Chemical Co., Ltd.), 18 March 2010 (18.03.2010), paragraphs [0034] to [0037] (Family: none) | 4-10,19-23 |
| A | JP 11-317475 A  (Canon Inc.), 16 November 1999 (16.11.1999), paragraph [0004] & US 6762508 B1          & US 2004/0229404 A1 & EP 939441 A2           & CN 1228614 A | 11-15 |
| A | JP 2001-354731 A  (NOF Corp.), 25 December 2001 (25.12.2001), paragraph [0002] (Family: none) | 11-15 |
| A | WO 2006/095762 A1  (Du Pont-Mitsui Polychemicals Co., Ltd.), 14 September 2006 (14.09.2006), table 2 & US 2009/0120489 A1     & EP 1863098 A1 & CN 101138095 A | 17 |
| A | JP 2008-211158 A  (Kabushiki Kaisha Dengiken), 11 September 2008 (11.09.2008), entire text; all drawings (Family: none) | 1-26 |

Form PCT/ISA/210 (continuation of second sheet) (July 2009)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004214641 A
- JP 8306947 A

- JP 3274702 B